# FASCICULE DE BREVET EUROPEEN

(11) **EP 3 107 149 B1**
(45) Date de publication et mention de la délivrance du brevet: **05.09.2018**
(21) Numéro de dépôt: 16174869.4
(22) Date de dépôt: 16.06.2016
(51) Int. Cl.: H01Q 1/38, H05K 1/02, H01Q 7/02, H05K 1/16, H04B 5/00

(54) **CIRCUIT IMPRIMÉ FLEXIBLE COMPRENANT UNE ANTENNE DE COMMUNICATION SANS CONTACT ET DISPOSITIF POUR TERMINAL DE PAIEMENT COMPRENANT UN TEL CIRCUIT IMPRIMÉ FLEXIBLE**
FLEXIBLE GEDRUCKTE LEITERPLATTE UMFASSEND EINER KONTAKTLOSEN KOMMUNIKATIONSANTENNE UND BAUGRUPPE FÜR ZAHLUNGSTERMINAL UMFASSEND SOLCH EINER FLEXIBLEN GEDRUCKTEN LEITERPLATTE
FLEXIBLE PRINTED CIRCUIT COMPRISING A CONTACTLESS COMMUNICATION ANTENNA AND DEVICE FOR PAYMENT TERMINAL COMPRISING SUCH A FLEXIBLE PRINTED CIRCUIT

(30) Priorité: 16.06.2015 FR 1555517
(43) Date de publication de la demande: 21.12.2016
(73) Titulaire: Ingenico Group, 75015 Paris (FR)
(72) Inventeur: ANDRE, Jérôme, 26800 MONTOISON (FR); HERNANDEZ, Vincent, 38780 OYTIER-SAINT-OBLAS (FR)
(74) Mandataire: Vidon Brevets & Stratégie

(56) Documents cités:
- EP-A2- 2 334 157
- WO-A1-89/08973
- WO-A1-2006/108472
- WO-A1-2007/042963
- DE-U1-202004 007 207
- JP-A- 2007 305 656
- US-A- 4 755 783
- US-A- 5 285 191
- US-A1- 2010 294 556
- US-A1- 2012 029 343
- US-A1- 2014 085 031
- US-B1- 7 180 001

## Description

### 1. Domaine de l'invention

L'invention se rapporte au domaine des antennes de communication. L'invention se rapporte plus particulièrement au domaine des antennes des antennes de communication pour dispositif portables, tels que des terminaux d'utilisateur ou des terminaux de paiement.

### 2. Art Antérieur

Aujourd'hui, les terminaux d'utilisateurs, tels que des smartphones, des tablettes mais également des terminaux de paiements intègrent différentes techniques de réception et de transmission de données sans fil : GSM, WIFI, Bluetooth, NFC. Ces techniques nécessitent la mise en oeuvre d'émetteurs/récepteurs et d'antennes. Les émetteurs/récepteurs se présentent souvent sous la forme de puces qui prennent place sur un circuit imprimé (également appelé PCB de l'anglais pour *« printed circuit board* »). Certaines puces émetteurs/récepteurs sont multistandards. Cela signifie qu'elles prennent en charge plusieurs techniques de transmission de données. Pour pouvoir fonctionner correctement, une puce émetteur/récepteur est notamment connectée à une antenne. L'antenne est un dispositif permettant de rayonner (émetteur) ou, de capter (récepteur), les ondes électromagnétiques.

L'une des techniques les plus récemment intégrée au sein de terminaux d'utilisateur est une technique de lecture sans contact. Par exemple, dans les terminaux d'utilisateur de types smartphone ou dans les terminaux de paiement, une technologie d'émission/transmission sans contact est souvent utilisée. Il s'agit par exemple d'une technique de communication en champ proche appelée NFC (de l'anglais pour « *near field communication »*). La communication en champ proche (CCP) est une technologie de communication sans fil à courte portée et haute fréquence. Cette technologie permet d'échanger des données entre deux dispositifs compatibles à une distance maximum de l'ordre de la dizaine de centimètres. Cette technologie est une extension de connexion de la norme qui définit les cartes de proximité utilisant la radio-identification (RFID de l'anglais « *radio frequency identification »*), qui combinent l'interface d'une carte à puce et un lecteur au sein d'un seul périphérique.

La mise en oeuvre de cette technique de transmission de données au sein des terminaux n'est pas sans poser quelques problèmes, notamment des problèmes d'intégration : l'espace disponible pour réaliser cette intégration est très réduit. En effet, les terminaux possèdent déjà de nombreuses fonctions de communication et de nombreuses antennes et il est difficile d'ajouter une telle antenne dans un terminal. D'autres contraintes sont également présentes, comme des concurrences entre fonctions de communication sans fils (des bandes de fréquence peuvent être proches, pour certaines de ces fonctions, et les modules d'émission et de réception de données peuvent recevoir des perturbations en provenance des autres modules de communications).

Par exemple, un terminal de paiement intègre de nombreux modules de lecture de carte de de paiement : cartes à puces, cartes à pistes et cartes sans contact. La technologie NFC et de plus en plus utilisée pour effectuer des paiements.

Pour la lecture de carte de paiement sans contact, il est nécessaire que le terminal de paiement soit équipé d'une antenne de communication sans contact. Compte tenu des contraintes d'intégration, de compacité et d'ergonomie, l'antenne sans contact du terminal est habituellement située au niveau du logement de l'imprimante ou autour de l'écran du terminal de paiement. Par ailleurs, dans le cadre d'un terminal de paiement, il faut que la transaction de paiement soit menée dans un laps de temps prédéterminé. Il est donc nécessaire que l'antenne sans contact permette une lecture claire (c'est-à-dire le moins parasitée possible) et rapide des données en provenance d'une carte de paiement sans contact. C'est l'une des raisons qui est à la base de la réalisation de l'antenne sans contact.

Ainsi, dans le cas d'un système de communication sans contact dont l'antenne est située autour de l'écran du terminal de paiement, lorsque l'utilisateur souhaite effectuer un paiement à l'aide de sa carte sans contact ou de son smartphone, il approche celui-ci de l'écran. Les concepteurs de terminaux de paiement ont en effet jugé que l'antenne nécessaire au paiement sans contact (antenne contactless), devait être placée en face ou à proximité de l'endroit où l'utilisateur présente son moyen de paiement.

Pari ailleurs, il est important de comprendre que le montage d'un terminal de paiement est une opération complexe, réalisé pour une bonne partie à la main, et que les concepteurs de terminaux doivent prendre en compte cet aspect lorsqu'ils conçoivent un nouveau terminal. L'adjonction d'une antenne sans contact, qui doit nécessairement être proche de la surface externe du terminal (pour que le rayonnement de l'antenne soit efficace), a donc été réalisée de la manière la plus simple possible tant en termes de montage qu'en termes de positionnement.

Pour ce faire, l'antenne sans contact est réalisée sous la forme d'un circuit imprimé flexible qui fait le tour de l'écran. Cette méthode de conception de l'antenne sans contact est avantageuse d'un certain point de vue. En effet, le montage de cette antenne est extrêmement simple. Il suffit de poser l'antenne autour de l'écran et de brancher le flexible dans un connecteur préalablement soudé sur la carte mère du terminal (connecteur FPC).

Cette méthode de conception de l'antenne sans contact pose cependant un problème économique. En effet, les circuits imprimés flexibles sont facturés lors de leur fabrication en fonction de la surface totale occupée par le circuit imprimé flexible. Autrement dit, comme l'antenne sans contact effectue le tour de l'écran, une partie substantielle de la surface de ce circuit imprimé flexible est facturée (le centre, qui est vide) alors même qu'elle n'est pas utilisée. On peut aisément comprendre que lorsque la taille d'un écran est par exemple de 12 cm², le fait de devoir payer un circuit imprimé flexible pour 12 cm² alors que seulement une infime partie de cette surface est réellement utilisée dans la fabrication du terminal pose un problème sensible au niveau du coût de fabrication du terminal.

Par ailleurs ce positionnement du circuit imprimé flexible autour de l'écran pose également un problème en termes d'interférence. En effet dans le domaine du terminal de paiement, les écrans tactiles qui sont utilisés ont la particularité d'incorporer une enveloppe métallique dont l'objectif est de permettre à l'écran de résister aux décharges électrostatiques. Or cette enveloppe métallique produit des interférences importantes au niveau de l'antenne lorsque celle-ci est utilisée.

Récemment, il a été proposé de positionner l'antenne de communication sans contact sur le pourtour du logement du rouleau de papier de l'imprimante. Cette solution est intéressante car elle diminue de manière sensible les interférences reçues de la part de l'écran, notamment.

Dans ce cas, l'antenne est constituée d'un bobinage de fil de cuivre dans une goulotte aménagée à cet effet sur une pièce plastique interne du terminal de paiement. La méthode de montage de l'antenne consiste à bobiner le fil de cuivre autour de la pièce plastique. Cette solution pose également problème car elle nécessite une place importante pour l'antenne. En effet, pour obtenir des performances convenables de l'antenne, convenable au paiement, il est nécessaire de réaliser au moins deux boucles avec un fil de cuivre. Ces boucles entrainent un chevauchement des fils de cuivre et donc entrainent la nécessité de prévoir, sur la pièce plastique interne, un espace suffisant pour ce chevauchement. Or les contraintes de compacité étant très fortes cette solution est notamment inadaptée aux terminaux de paiement. La demande de brevet japonais JP2007305656 décrit une antenne de type bobine comprenant un support flexible et un circuit imprimé sur le support flexible. L'antenne de type bobine présente une forme longitudinale dans un état initial. Elle peut être transformée, dans un état final, en une antenne de forme rectangulaire par des opérations de pliage.

La demande PCT WO89/08973 divulgue un élément inductif comprenant un substrat déformable et une piste conductrice sur le substrat. La piste conductrice prend une forme serpentine et peut être disposée sur une ou deux faces du substrat. L'élément inductif peut être déformé d'une manière prédéterminée afin de former une bobine adaptée à être utilisé comme une antenne.

La demande de brevet américain US2012002943A1 divulgue une bobine inductrice sur un substrat flexible. La bobine peut être utilisée comme une antenne dans un dispositif électronique pour transmettre et pour recevoir des données.

Une autre amende de brevet américain US5285191 divulgue un marqueur LC comprenant un circuit résonant. Le marqueur LC comprend un élément inductif formé par des pistes conductrices, un élément capacitif formé par des pistes conductrices et des couches diélectriques superposées, et une couche adhésive disposée entre les deux éléments. Il est donc nécessaire de disposer d'une solution pour la fabrication et le montage d'une antenne qui puisse permettre de résoudre ces problématiques de l'art antérieur.

### 3. Résumé

La présente divulgation permet de résoudre au moins certains des problèmes posés par les antennes de communication sans contact de l'art antérieur. La présente divulgation se rapporte plus particulièrement à un circuit imprimé flexible de forme longitudinale, comprenant au moins une piste conductrice s'étendant sur la longueur du circuit imprimé flexible, le circuit imprimé flexible comprenant au moins une zone de pliage conformée pour autoriser le passage dudit circuit imprimé flexible d'un état déplié à un état plié dans lequel la piste conductrice forme au moins une boucle d'antenne.

Ainsi, il est possible de disposer d'une antenne simple et économique à réaliser, tout en permettant de disposer celle-ci dans un espace tridimensionnel plutôt qu'à plat comme cela peut être le cas traditionnellement.

Selon l'invention un tel circuit imprimé flexible comprend :
- au moins deux pistes conductrices s'étendant sur la longueur du circuit imprimé flexible, lesdites au moins deux pistes conductrices étant sensiblement parallèles entre elles ;
- au moins une zone de recouvrement d'une première extrémité du circuit imprimé sur une deuxième extrémité dudit circuit imprimé.

Il est ainsi possible d'attacher l'antenne dans un espace tridimensionnel.

Selon une caractéristique particulière, la zone de recouvrement comprend des moyens de connexion des dites au moins deux pistes conductrices entre elles afin de former un nombre prédéfini de boucles d'antenne.

Il est ainsi possible de faire en sorte que les pistes de circuit imprimé, une fois recouvertes les unes sur les autres, soient utilisées pour matérialiser les spires d'une antenne multispires.

Selon un mode de réalisation particulier, le circuit imprimé flexible comprend une extension de connexion dudit circuit imprimé flexible sur un connecteur idoine.

Ainsi, la fixation de l'antenne sur un circuit imprimé est simple puisqu'il suffit de connecter l'extension de connexion. Aucune opération de soudure n'est alors nécessaire.

Selon un mode de réalisation particulier, le circuit imprimé flexible comprend au moins un orifice de fixation dudit circuit imprimé flexible sur au moins un support d'antenne.

Il est ainsi possible de fixer l'antenne sur un boitier ou sur un support de manière simple, ce qui facilite grandement le montage de l'antenne.

Selon un autre aspect, la technique proposée se rapporte également à un dispositif comprenant des moyens de communication sans fil mettant en oeuvre un émetteur transmetteur et une antenne. Un tel dispositif comprend un circuit imprimé flexible tel que décrit préalablement.

Selon une caractéristique particulière, un tel dispositif comprend au moins une pièce support sur laquelle l'antenne est positionnée.

### 4. Figures

D'autres caractéristiques et avantages apparaîtront plus clairement à la lecture de la description suivante d'un mode de réalisation particulier de la divulgation, donné à titre de simple exemple illustratif et non limitatif, et des dessins annexés, parmi lesquels :
- les figures 1a et 1b illustrent un flex en position dépliée et en position repliée pour réaliser une antenne de réception/transmission de données selon la présente technique ;
- la figure 2 illustre un mode de réalisation en position dépliée ;
- la figure 3 illustre de manière plus précise un mode de réalisation de la figure 2 en position dépliée ;
- la figure 4 illustre le mode de réalisation de la figure 2 en position repliée ;
- les figures 5 et 6 illustrent de manière plus précise le mode de réalisation de la figure 3 en position repliée.

### 5. Description

Comme explicité préalablement, la solution proposée consiste à réaliser une antenne en circuit imprimé flexible. Pour réduire les coûts de fabrication par rapport aux antennes antérieures, également réalisée en circuit imprimé flexible, une première caractéristique de la technique proposée consiste à définir un circuit imprimé flexible en longueur dans une position dépliée de l'antenne. Ainsi, plutôt que de devoir évider un flex (et donc de payer pour la partie, centrale, évidée), le flex formant antenne est dessiné en longueur puis replié préalablement ou concomitamment au montage de l'antenne.

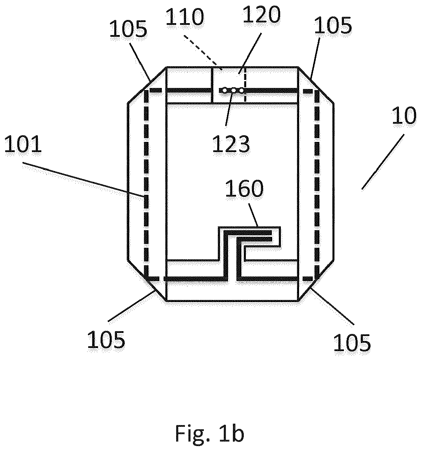

La figure la illustre une version basique de l'antenne selon la présente technique. Une telle antenne se présente sou la forme d'un circuit imprimé flexible 10 de forme rectangulaire. La largeur du circuit imprimé est adapté au nombre de piste du circuit et donc au nombre de spire de cuivre de l'antenne. Sur l'exemple de la figure la, le circuit imprimé flexible comprend une seule piste 101 de cuivre et une extension de connexion 160 permettant de connecter l'antenne à un connecteur prévu à cet effet sur une carte mère du terminal. La figure 1b présente l'antenne de la figure la sous sa forme pliée. Comme on peut le constater sur cet exemple de la figure 1b, le pliage est antagoniste. Cela signifie que pour obtenir une antenne à une spire qui est située sur le pourtour d'un écran, par exemple, le circuit imprimé est plié par exemple à quarante-cinq degrés, quatre fois, (suivant les pointillés 105, de la figure la, qui définissent les zones de pliage) alternativement à droite puis à gauche, de sorte que, lors du pliage, la piste de cuivre ne soit pas en contact avec elle-même. Le pliage, selon la présente technique peut être un pliage à plat, comme exposé précédemment ou bien un pliage intermédiaire, qui peut alors être considéré comme une déformation plus qu'un réel pliage. On obtient ainsi une antenne dont les caractéristiques sont les mêmes qu'avec un circuit imprimé flexible « évidé », mais avec un cout de réalisation bien inférieur, car justement il n'est pas nécessaire de payer pour la partie évidée du flexible. Par ailleurs, on déduit également grandement les déchets liés à la fabrication de l'antenne. Ainsi, ce simple exemple permet de résoudre les problèmes liés à la fabrication d'une antenne qui doit être positionnée sur le pourtour d'un écran. Dans cet exemple, le circuit imprimé flexible comprend deux extrémités de superposition 110, 120. Ces zones sont reliées entre elles lors du liage, pour permettre la création de la boucles (ou des boucles lorsqu'il y a plusieurs pistes). L'une de ces extrémités de superposition peut comprendre des moyens de fixation (123), tels que des orifices de soudures, pour permettre le maintien, dans la position repliée, de l'antenne. Des points de colle conductrice peuvent également être utilisés.

Bien entendu, d'autres modes de réalisation plus complexes peuvent être envisagés, tels que ceux qui sont décrits par la suite. Cependant, le principe général consiste bien à disposer d'un circuit imprimé flexible de forme longitudinale, comprenant au moins une piste de cuivre (le nombre de pistes de cuivre représente le nombre de spires de l'antenne), le circuit imprimé flexible comprenant au moins une zone de pliage conformée pour permettre le passage du circuit imprimé flexible d'un état déplié à un état plié dans lequel la piste de cuivre forme au moins une boucle d'antenne.

Le pliage du circuit imprimé flexible peut être réalisé soit à la main soit à l'aide d'une plieuse adaptée. La définition du plan du circuit imprimé flexible (c'est-à-dire de la forme dépliée du circuit imprimé flexible) tient compte, le cas échéant, de la zone de pliage ou de la perte au pli. Il est entendu, comme indiqué précédemment, que la pliage n'est pas nécessairement un pliage à plat, mais peut également être un pliage qualifié de partiel ou une déformation.

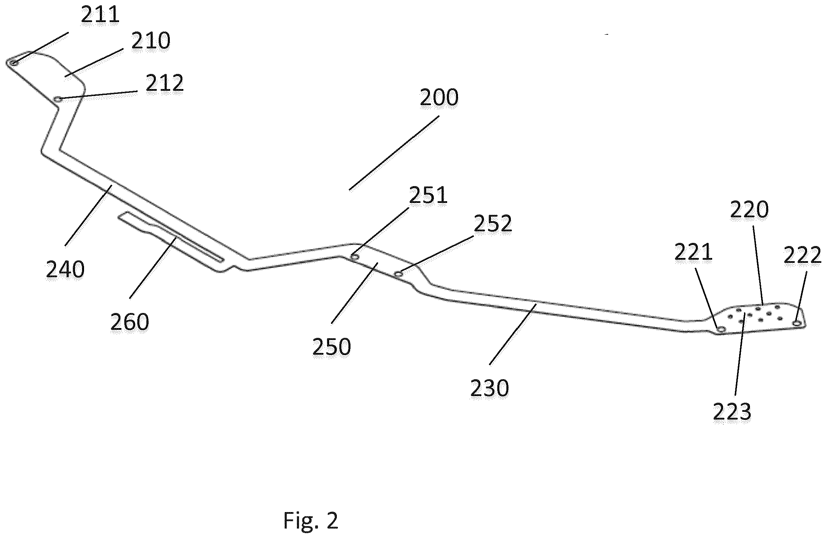

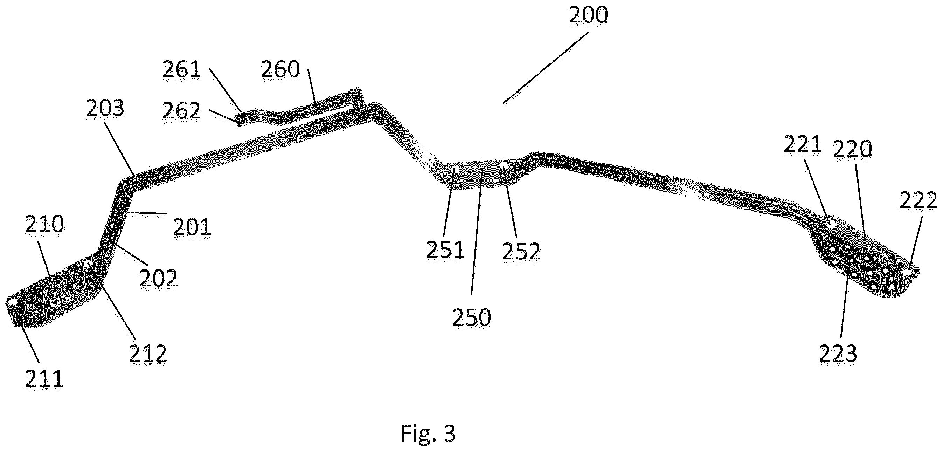

La figure 2 illustre un flex en position dépliée selon un mode de réalisation de l'invention. Le flex 10 est dessiné en longueur dans une position dépliée et comprend deux extrémités de superposition 210, 220, une zone centrale 250 et deux zones latérales 230, 240. Les deux zones de superposition 210, 120 et la zone centrale comprend chacune deux orifices de fixation 111,112, 221, 222, 151, 152. Une des deux zones de superposition 210, 220 comprend des trous 223 pour la soudure des deux zones de superposition 210, 220. Une extension de connexion 260, permettant de connecter l'antenne à un connecteur prévu à cet effet sur une carte mère, est disposée sur une des deux zones latérales 130, 140. La figure 3 illustre un flex selon un mode réalisation spécifique de l'invention. Le circuit imprimé flexible 200 comprend trois pistes de cuivre 201, 202, 203. Des trous 221, 222, 223 sont disposés sur les pistes en cuivre dans l'extrémité de superposition 220. Les trous 221 et 222 sont destinés à attacher l'antenne sur la pièce réceptrice, à des emplacements prévus à cet effet. Les trous 223 sont destinés à permettre une soudure des deux zones de superposition 210 et 220. L'extension de connexion 260 comprend deux points de soudage 261, 262 pouvant être soudés ou enfichés sur un connecteur sur la carte mère du terminal de paiement.

À la différence de la solution de l'art antérieur, le flex en longueur permet de déduire le coût de matière. En effet, dans la solution de l'art antérieur, le flex est dessiné en forme de boucle. Le centre de la boucle est par la suite creusé afin de réaliser l'antenne. Cette partie creusée reste toujours payantes pour le fabriquant. Ainsi, le flex en longueur dans une position dépliée selon l'invention permet d'éviter de payer pour la partie vide de la solution de l'art antérieur.

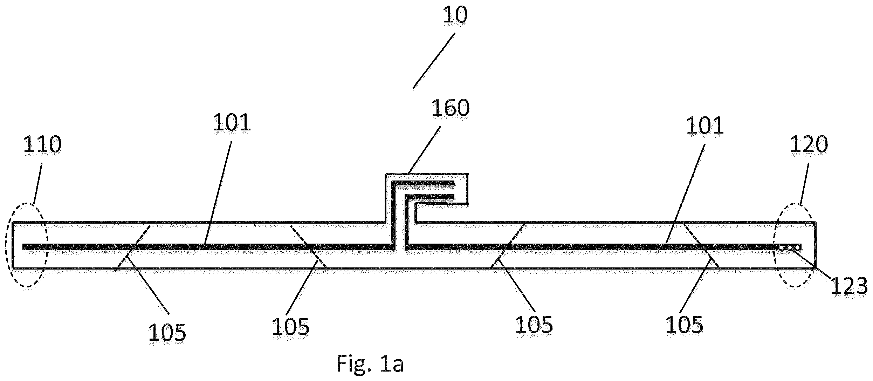

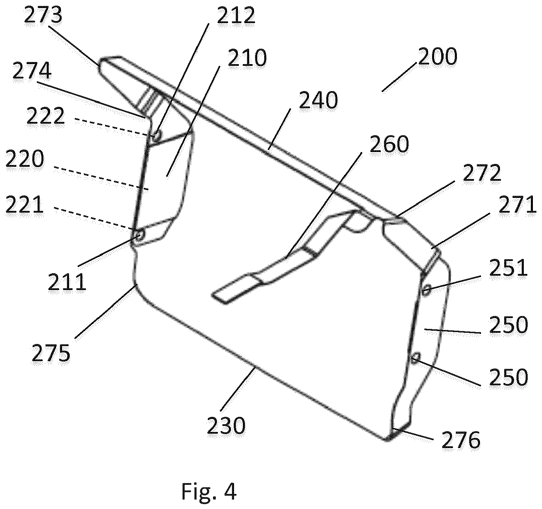

La figure 4 illustre un flex 200 en position repliée, qui forme une antenne de communication sans contact dans un terminal de paiement selon un mode de réalisation de l'invention. Le flex en position repliée (antenne) est réalisé par une opération de pliage ou de déformation du flex en positon dépliée 100 illustrée dans la Figure 1. Cette opération de pliage est réalisée sur plusieurs zones de repli 271, 272, 273, 274, 275, 276. Le flex en position repliée comprend deux extrémités de superposition 210, 220, une zone centrale 250 et deux zones latérales 230, 240. Les deux zones de superposition 210, 220 et la zone centrale comprend chacune deux orifices de fixation 211,212, 221, 222, 251, 252 permettant de fixer l'antenne sur la pièce support dans le terminal de paiement. Dans cette position repliée, les deux orifices de fixation 211, 212 sur une extrémité de superposition 210 coïncident respectivement avec les deux orifices de fixation 221, 222 sur l'autre extrémité de superposition 220. Une des deux extrémités de superposition 210, 220 comprend des trous (non représentés) pour la soudure des deux zones de superposition 210, 220.

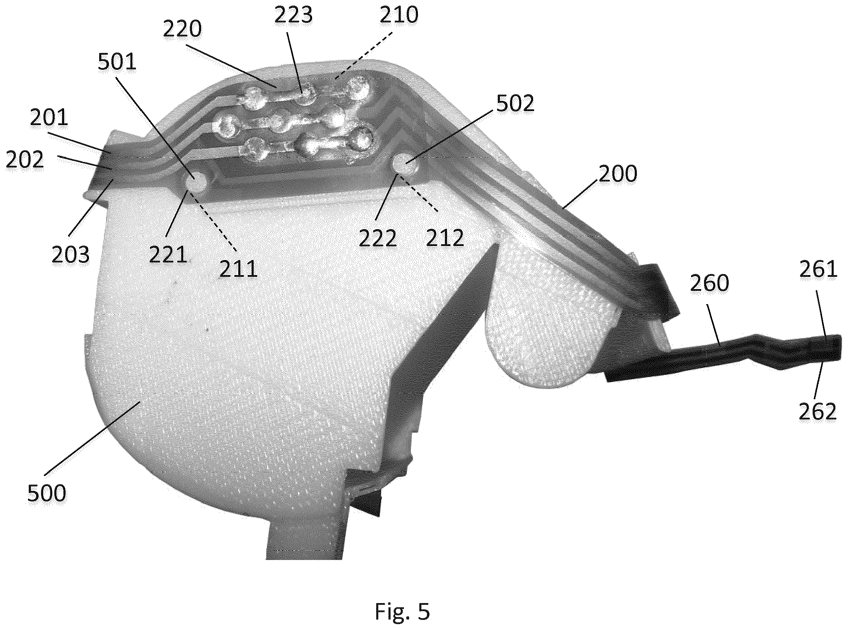

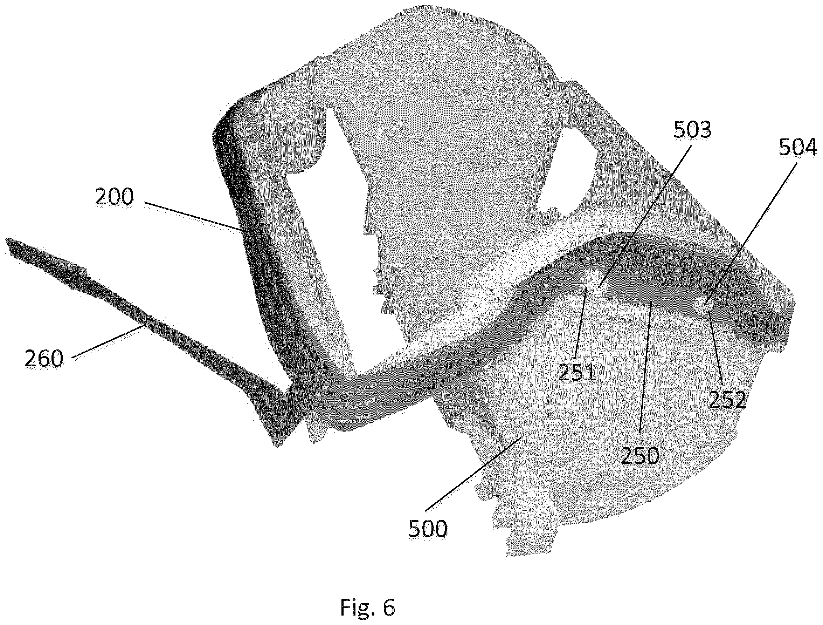

Les figures 5, 6 et 7 illustrent la fermeture de la boucle du flex lors du montage de l'antenne sur une pièce support, qui est dans ce mode de réalisation un logement 500 de rouleau de papier. Les deux extrémités de superposition 210, 220 se superposent et sont fixées par soudure. La soudure est réalisée en positionnant les trous 223 sur les trois pistes en cuivre 201, 202, 203 dans l'extrémité de superposition 220 qui se replie au-dessus et des plages sur l'autre extrémité de superposition 210 qui est située en dessous. Les extrémités des pistes en cuivre 201, 203 et 203 dans l'extrémité de superposition 220 sont respectivement soudées sur les autres extrémités des pistes 203, 201 et 202 sur l'extrémité de superposition 210, à travers des trous 223. Une telle soudure permet à la fois de fermer la boucle de flex 200, et aussi de relier les trois pistes en cuivre 201, 203, 203 pour définir le nombre de boucles de l'antenne (en l'occurrence trois dans ce mode de réalisation). En effet, la superposition des deux extrémités est définie de sorte que la piste 201 soit soudée avec la piste 202, qui est elle-même soudée avec la piste 203 : on obtient ainsi, à l'issue de l'opération de soudure, une unique piste conductrice, formant trois tours autour de la pièce support (le logement 500). Les orifices de fixation 221, 222 sur l'extrémité de superposition 220 se superposent respectivement sur les orifices de fixation 211, 212 sur l'extrémité de superposition 210, et forme deux orifices de fixation superposés. La forme du flex 200 replié s'adapte à la forme externe du logement 500. Lors de montage, deux moyens de fixations 501, 502 (des plots, des clips) disposés sur le logement 500 traversent les deux orifices de fixation superposés. Sur l'autre côté du logement comme illustré dans la figure 6, deux moyens de fixation 503, 504 traversent les deux orifices de fixation 251, 252 disposées sur la zone centrale 250 du flex. Le diamètre des moyens de fixation 501, 502, 503, 504 (plots, clips) est supérieur ou égal à celui des orifices de fixations 211, 212, 221, 222, 251, 252, et permet aux moyens de fixation de maintenir le flex tout en maintenant la facilité du montage du flex. Lors du montage du terminal de paiement, les deux points de soudage 261, 262 sont soudés sur la carte mère du terminal de paiement. L'antenne devient ainsi opérationnelle pour la réception et l'émission des signaux.

Selon un autre mode de réalisation, les deux extrémités de superposition 210, 220 sont superposées et repliées dans une zone sur un PCB et fixées sur celui-ci avec un connecteur à travers des orifices de fixation 211, 212, 221, 222. Les deux extrémités de superposition 210, 220 peuvent toutefois être positionnées sans se superposer dans une zone sur le PCB et fixées sur celui-ci avec deux connecteurs à travers des orifices de fixation 211, 212, 221, 222.

Selon un autre mode de réalisation, le flex en position repliée comprend deux extrémités qui se superposent sur une zone de repli. La fermeture de la boucle est réalisée par l'agrafage ou crimp des deux extrémités superposées.

## Revendications

1. Circuit imprimé flexible (10, 200) de forme longitudinale, comprenant au moins une piste conductrice (101, 201, 202, 203) s'étendant sur la longueur du circuit imprimé flexible, le circuit imprimé flexible comprenant au moins une zone de pliage (105, 205) conformée pour autoriser le passage dudit circuit imprimé flexible d'un état déplié à un état plié dans lequel la piste conductrice forme au moins une boucle d'antenne, **caractérisé en ce qu'**il comprend :
- au moins deux pistes conductrices (201, 202, 203) s'étendant sur la longueur du circuit imprimé flexible, lesdites au moins deux pistes conductrices (201, 202, 203) étant sensiblement parallèles entre elles ;
- au moins une zone de recouvrement (110, 120, 210, 220) d'une première extrémité du circuit imprimé sur une deuxième extrémité dudit circuit imprimé

2. Circuit imprimé flexible (10, 200) selon la revendication 1, **caractérisé en ce que** la zone de recouvrement comprend des moyens de connexion (223) des dites au moins deux pistes conductrices entre elles afin de former un nombre prédéfini de boucles d'antenne.

3. Circuit imprimé flexible selon la revendication 1, **caractérisé en ce qu'**il comprend une extension de connexion (160, 260) dudit circuit imprimé flexible sur un connecteur idoine.

4. Circuit imprimé flexible selon la revendication 1, **caractérisé en ce qu'**il comprend au moins un orifice de fixation (211, 212, 221, 222, 251, 252) dudit circuit imprimé flexible sur au moins un support d'antenne.

5. Dispositif comprenant des moyens de communication sans fil mettant en oeuvre un émetteur transmetteur et une antenne, dispositif **caractérisé en ce que** ladite antenne comprend un circuit imprimé flexible selon l'une quelconque des revendications 1 à 4.

6. Dispositif, selon la revendication 5, **caractérisé en ce qu'**il comprend au moins une pièce support (500) sur laquelle ladite antenne est positionnée.

## Patentansprüche

1. Flexible Leiterplatte (10, 200) von länglicher Form, umfassend mindestens eine Leiterbahn (101, 201, 202, 203), die sich über die Länge der flexiblen Leiterplatte erstreckt, wobei die flexible Leiterplatte mindestens einen Faltbereich aufweist 105, 205), der ausgebildet ist, um den Übergang der flexiblen Leiterplatte von einem entfalteten Zustand in einen gefalteten Zustand zu ermöglichen, in dem die Leiterbahn mindestens eine Antennenschleife bildet, **dadurch gekennzeichnet, dass** sie aufweist:
- mindestens zwei Leiterbahnen (201, 202, 203), die sich über die Länge der flexiblen Leiterplatte erstrecken, wobei die mindestens zwei Leiterbahnen (201, 202, 203) im Wesentlichen parallel zueinander sind,
- mindestens einen Überlappungsbereich (110, 120, 210, 220) eines ersten Endes der Leiterplatte auf einem zweiten Ende der Leiterplatte.

2. Flexible Leiterplatte (10, 200) nach Anspruch 1, **dadurch gekennzeichnet, dass** der Überlappungsbereich Mittel zum Verbinden (223) der mindestens zwei Leiterbahnen untereinander aufweist, um eine vorbestimmte Anzahl an Antennenschleifen zu bilden.

3. Flexible Leiterplatte nach Anspruch 1, **dadurch gekennzeichnet, dass** sie eine Erweiterung der Verbindung (160, 260) der flexiblen Leiterplatte auf einem geeigneten Steckverbinder aufweist.

4. Flexible Leiterplatte nach Anspruch 1, **dadurch gekennzeichnet, dass** sie mindestens ein Befestigungsloch (211, 212, 221, 222, 251, 252) der flexiblen Leiterplatte auf mindestens einem Antennenträger aufweist.

5. Vorrichtung, umfassend drahtlose Kommunikationsmittel, die einen Sender-Empfänger und eine Antenne einsetzen, Vorrichtung, die **dadurch gekennzeichnet ist, dass** die Antenne eine flexible Leiterplatte nach einem der Ansprüche 1 bis 4 aufweist.

6. Vorrichtung nach Anspruch 5, **dadurch gekennzeichnet, dass** das sie mindestens ein Trägerteil (500) aufweist, auf dem die Antenne angeordnet ist.

## Claims

1. Flexible printed circuit board (10, 200) of longitudinal shape comprising at least one conductive track (101, 201, 202, 203) extending over the length of the flexible printed circuit, the flexible printed circuit board comprising at least one folding area (105, 205) shaped so as to allow said flexible printed circuit board to pass from an unfolded state to a folded state in which the conductive track forms at least one antenna loop, **characterized in that** it comprises:
- at least two conductive tracks (201, 202, 203) extending over the length of the flexible printed circuit board, said at least two conductive tracks (201, 202, 203) being substantially parallel to each other;
- at least one covering area (110, 120, 210, 220) where a first end of the printed circuit board covers a second end of said printed circuit board.

2. Flexible printed circuit board (10, 200) according to claim 1, **characterized in that** the covering area comprises means (223) for connecting said at least two conductive tracks to each other in order to form a predefined number of antenna loops.

3. Flexible printed circuit board according to claim 1, **characterized in that** it comprises a connection extension (160, 260) of said flexible printed circuit board on an appropriate connector.

4. Flexible printed circuit board according to claim 1, **characterized in that** it comprises at least one orifice (211, 212, 221, 222, 251, 252) for affixing said flexible printed circuit board to at least one antenna support.

5. Device comprising wireless communications means implementing a transceiver and an antenna, **characterized in that** said antenna comprises a flexible printed circuit board according to any one of the claims 1 to 4.

6. Device, according to claim 5, **characterized in that** it comprises at least one supporting part (500) on which said antenna is positioned.
